# EUROPEAN PATENT APPLICATION

(11) **EP 3 112 503 A1**
(43) Date of publication of application: **04.01.2017**
(21) Application number: 14883763.6
(22) Date of filing: 08.10.2014
(51) Int. Cl.: C30B 11/00, C30B 29/12

(54) **CRUCIBLE FOR CRYSTAL GROWTH, CRYSTAL GROWTH APPARATUS PROVIDED THEREWITH, AND METHOD FOR GROWING CRYSTALS**

(30) Priority: 27.02.2014 JP 2014036375
(71) Applicant: Hitachi, Ltd., Chiyoda-ku, Tokyo 100-8280 (JP)
(72) Inventor: KANDA Takayuki, Tokyo 100-8280 (JP); KOMINAMI Shinya, Tokyo 100-8280 (JP); UENO Yuichiro, Tokyo 100-8280 (JP); ISHITSU Takafumi, Tokyo 100-8280 (JP); SEINO Tomoyuki, Tokyo 100-8280 (JP); TAKAHASHI Isao, Tokyo 100-8280 (JP)
(74) Representative: MERH-IP Matias Erny Reichl Hoffmann Patentanwälte PartG mbB
(86) International application number: PCT/JP2014/077016
(87) International publication number: WO 2015/129091

(57) **Abstract**

A crucible provided with a holding section (12) for holding a raw material (20), an initial distillate recovery section (14) for recovering an initial distillate (24) when the raw material (20) held in the holding section (12) has been vaporized, a main distillate condensing section (16) for condensing a main distillate when the raw material (20) held in the holding section (12) has been vaporized, and a crystal growing section (18) for holding the main distillate (30) comprising a raw material melt (28) condensed by the main distillate condensing section (16) and producing crystals when crystals are grown from the held main distillate (30) is used as a crucible (10) for crystal growth used to grow crystals. This makes it possible to raise the efficiency of manufacturing crystals while achieving high purification of a raw material for semiconductor crystals.

## Description

### Technical Field

The present invention relates to: a crucible for crystal growth suitable for growing a highly pure crystal; a crystal growing apparatus provided therewith; and a method for growing crystals.

### Background Art

There is a method described in Patent Literature 1 for example as a method for manufacturing a crystal of a detector section in a radiation detector.

Patent Literature 1 describes a container for growing a single crystal, which is made of quartz, includes a melt holding section having a large diameter and a thin crystal growing section passing through the center of the melt holding section and extending downward, and is structured so that a melt may not flow directly into the crystal growing section and the lower circumference of the melt holding section may be coupled with the crystal growing section.

### Citation List

### Patent Literature

Patent Literature 1: Japanese Unexamined Patent Application Publication No. Sho 61-201690

### Summary of Invention

### Technical Problem

In recent years, attention is focused on the use of a semiconductor detector in single photon emission computed tomography (SPECT) and computed tomography (CT) using X-rays.

A combination of a scintillator that emits light when it receives an X-ray or a gamma ray and a photomultiplier to amplify the light has heretofore been used for a detector in such a device. In recent years in contrast, information on the energy of an incident photon has been able to be obtained by replacing a scintillator with a semiconductor detector and used for improving the efficiency of medical examination and the quality of an obtained image.

The principle of a semiconductor detector is that the step of introducing a radiant ray into an electric field generated by applying a high voltage in the state of placing a semiconductor crystal and moving electric charge carriers (electrons and positive holes) generated by the interaction between the radiant ray and the semiconductor crystal by the electric field is extracted as an electric signal.

Here, since the capture or recombination of the electric charge carriers is promoted by impurities existing in the semiconductor crystal, the mobility (µ) of the electric charge carriers decreases and the average lifetime (τ) also reduces as the impurity concentration increases.

Further, it is generally known that a detected electric signal increases as the distance which electric charge carriers travel toward an electrode increases, and the superiority of a semiconductor for a detector increases as the capture length of electric charge carriers per an electric field, namely a product µτ that is a product of a mobility and an average lifetime, increases.

Meanwhile, when an impurity concentration is very high, the electric resistance of a semiconductor crystal decreases due to the electric charge carriers derived from impurities, an electric current flows steadily by an electric field, and hence a minute electric signal generated by a radiant ray cannot be detected undesirably.

In this context, the improvement of the degree of purity in a semiconductor crystal is very important for obtaining excellent properties as a detector. Further, it is also necessary to reduce structural defects, namely to be a single crystal, because the structural defects in a crystal lattice function similarly to impurities.

Meanwhile, since electric charge carriers are generated by not only a radiant ray but also heat, when the band gap energy of a semiconductor crystal is small, the influence of the heat is large and the semiconductor crystal does not function as a radiation detector unless it is cooled. In contrast, in a semiconductor crystal having band gap energy larger than 1.5 eV, the influence of heat is small and the semiconductor crystal may possibly be used even at a temperature close to room temperature.

As semiconductor crystals studied for being used in a radiation detector operating at a temperature close to room temperature, cadmium telluride, cadmium/zinc/tellurium, gallium arsenide, and thallium bromide are named. As the atomic number of an atom constituting a semiconductor crystal increases and the density of a crystal increases, the thickness necessary for stopping a radiant ray can be reduced and hence the advantage in manufacturing a detector increases. In particular, thallium bromide is highly expected because it comprises thallium of Atomic Number 81 and bromine of Atomic Number 35, has a high density of 7 g/cm³, and further has large band gap energy of about 2.7 eV. The purity of a commercially-available thallium bromide material is about 99.999% at most however and hence a highly-purifying treatment is essential for using it in the manufacture of a radiation detector.

Meanwhile, in the manufacture of a semiconductor crystal, it is necessary to highly purify a raw material efficiently and sufficiently but both the efficiency and the sufficiency are hardly obtained simultaneously.

For example, the method described in Patent Literature 1 has the advantages that the method can be used for simple vacuum distillation and a raw material after refined can be used directly for growing a crystal although the method is not aimed at the high purification of the raw material originally.

A problem of a container described in Patent Literature 1, however, is that, in impurities, an impurity more likely to vaporize than a target component (a raw material for crystal growth) is hardly removed and hence the container cannot be compatible with a higher degree of purification.

An object of the present invention is to provide: a crucible for crystal growth capable of increasing the manufacturing efficiency of a crystal while the raw material of a semiconductor crystal is attempted to be highly purified; a crystal growing apparatus provided therewith; and a method for growing the crystal.

### Solution to Problem

In order to solve the above problem, the configurations described in Claims are adopted for example.

The present invention includes the means for solving the problems stated above and an example of the invention is characterized by having a retaining section for retaining a raw material, an initial distillate recovery section for recovering an initial distillate when the raw material retained in the retaining section has been vaporized, and a crystal growing section for recovering a main distillate when the raw material retained in the retaining section has been vaporized and growing a crystal.

### Advantageous Effects of Invention

The present invention makes it possible to increase the manufacturing efficiency of a crystal while the raw material of a semiconductor crystal is attempted to be highly purified. Brief Description of Drawings

Fig. 1 is a schematic view showing the structure of a crucible for crystal growth in a first embodiment according to the present invention.
Fig. 2 is a schematic view showing an example of a crystal growing apparatus of a semiconductor in the first embodiment according to the present invention.
Fig. 3 is a flowchart showing an example of a method for growing a semiconductor crystal using a crucible for crystal growth according to the present invention in the first embodiment according to the present invention.
Fig. 4 is a schematic view showing an example of the state of a crucible for crystal growth and the movement of a raw material during initial distillate recovery in the first embodiment according to the present invention.
Fig. 5 is a schematic view showing an example of the state of a crucible for crystal growth and the movement of a raw material during main distillate recovery in the first embodiment according to the present invention.
Fig. 6 is a schematic view showing an example of the state of a crucible for crystal growth at the end of main distillate recovery in the first embodiment according to the present invention.
Fig. 7 is a schematic view showing the structure of a crucible for crystal growth in a second embodiment according to the present invention.
Fig. 8 is a schematic view showing the structure of a crucible for crystal growth in a third embodiment according to the present invention.
Fig. 9 is a schematic view showing the structure of a crucible for crystal growth in a fourth embodiment according to the present invention.
Fig. 10 is a schematic view showing the structure of a crucible for crystal growth in a fifth embodiment according to the present invention.
Fig. 11 is a schematic view showing the structure of a crucible for crystal growth in a sixth embodiment according to the present invention.
Fig. 12 is a schematic view showing the structure of a crucible for crystal growth in a seventh embodiment according to the present invention.
Fig. 13 is a schematic view showing the structure of a crucible for crystal growth in an eighth embodiment according to the present invention.
Fig. 14 is a schematic view showing the structure of a crucible for crystal growth in a ninth embodiment according to the present invention.

### Description of Embodiments

Embodiments of a crucible for crystal growth, a crystal growing apparatus provided therewith, and a method for growing a crystal according to the present invention are hereunder explained in reference to the drawings.

### <First Embodiment>

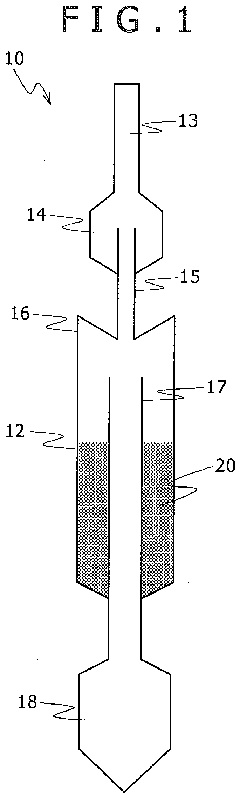

A first embodiment of a crucible for crystal growth, a crystal growing apparatus provided therewith, and a method for growing a crystal according to the present invention is explained in reference to Figs. 1 to 6. Here, in Figs. 1 to 6, the explanations are made on the basis of the case of growing a crystal of thallium bromide.

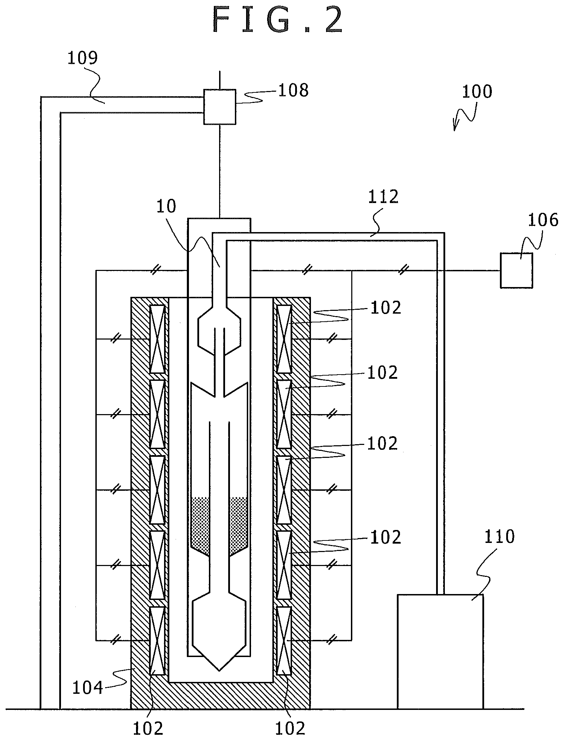

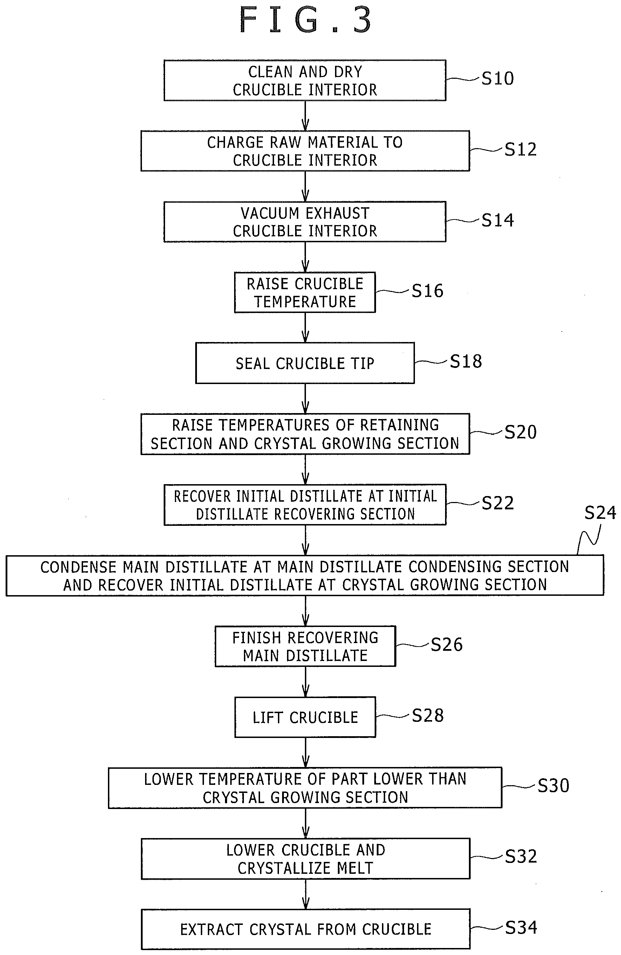

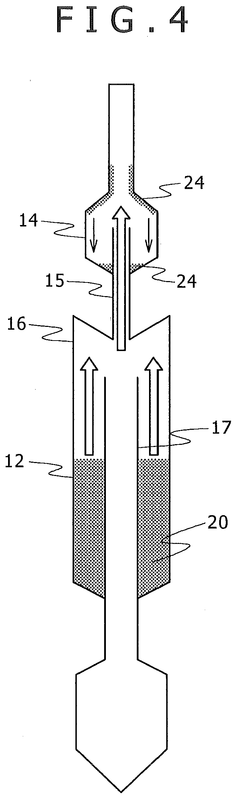

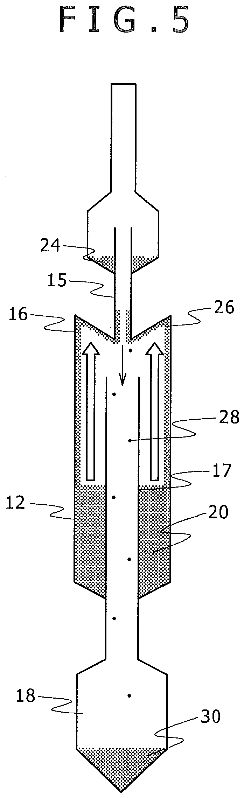

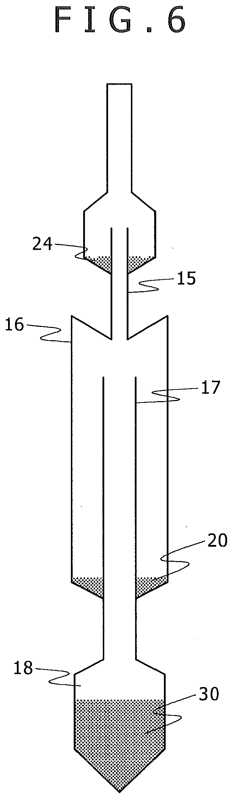

Fig. 1 is a schematic view showing the structure of a crucible for crystal growth in the first embodiment according to the present invention, Fig. 2 is a schematic view showing an example of a crystal growing apparatus of a semiconductor in the first embodiment according to the present invention, Fig. 3 is a flowchart showing an example of a method for growing a semiconductor crystal using a crucible for crystal growth according to the present invention in the first embodiment according to the present invention, Fig. 4 is a schematic view showing an example of the state of a crucible for crystal growth and the movement of a raw material during initial distillate recovery in the first embodiment according to the present invention, Fig. 5 is a schematic view showing an example of the state of a crucible for crystal growth and the movement of a raw material during main distillate recovery in the first embodiment according to the present invention, and Fig. 6 is a schematic view showing an example of the state of a crucible for crystal growth at the end of main distillate recovery in the first embodiment according to the present invention.

In Fig. 1, a crucible 10 for crystal growth schematically includes a retaining section 12, a straight pipe section 13, an initial distillate recovery section 14, a main distillate condensing section 16, and a crystal growing section 18.

The retaining section 12 has a shape of protruding the top end of a pipe section 17 connected to the crystal growing section 18 from downward and the retaining section 12 retains a raw material 20 in the manner of being separated from other sections by protruding the pipe section 17 from downward.

The initial distillate recovery section 14 is a section to recover an initial distillate when the raw material 20 retained in the retaining section 12 is vaporized and the top end of a pipe section 15 connected to the retaining section 12 protrudes from the bottom part of the initial distillate recovery section 14. The diameter of the pipe section 15 is smaller than the diameter of the pipe section 17 and the initial distillate recovery section 14 retains an initial distillate 24 in the manner of being separated from other sections by protruding the pipe section 15 from the bottom part of the initial distillate recovery section 14.

The main distillate condensing section 16 is a section to condense a main distillate when the raw material 20 retained in the retaining section 12 is vaporized and is arranged between the initial distillate recovery section 14 and the crystal growing section 18 that will be described later. In the main distillate condensing section 16, the terminal end of the pipe section 15 protrudes in the shape of a downward convex and a raw material 26 condensed and liquefied at the downward convex section of the main distillate condensing section drops naturally by the gravity and is recovered at the crystal growing section 18 through the pipe section 17.

The crystal growing section 18 is a section that retains a main distillate 30 comprising a raw material melt 28 condensed at the main distillate condensing section 16 and generates a crystal when the crystal is grown from the retained main distillate 30.

The straight pipe section 13 is a tubular section communicating with a vacuum exhaust pipe 112 (refer to Fig. 2) of a vacuum exhauster 110 (refer to Fig. 2) for depressurizing the interior of the crucible 10 for crystal growth and is arranged above the initial distillate recovery section 14.

The overall schematic configuration of a crystal growing apparatus is explained hereunder in reference to Fig. 2.

As shown in Fig. 2, a crystal growing apparatus 100 schematically has a crucible 10 for crystal growth shown in Fig. 1, a heating furnace 104 for heating the crucible 10 for crystal growth, a lifting and lowering device 108, and a vacuum exhauster 110.

The heating furnace 104 has multi-staged heaters 102 capable of controlling the temperatures of the sections (a retaining section 12, an initial distillate recovery section 14, a main distillate condensing section 16, and a crystal growing section 18) of the crucible 10 for crystal growth independently and a heater control section 106 to control the temperatures of the multi-staged heaters 102 individually.

The lifting and lowering device 108 is a device for lifting and lowering the crucible 10 for crystal growth and is supported by a support 109. The crucible 10 for crystal growth is suspended by the lifting and lowering device 108 and can be moved vertically when needed.

The vacuum exhauster 110 is a device for evacuating the air in the crucible 10 for crystal growth and is connected to a straight pipe section 13 of the crucible 10 for crystal growth through a vacuum exhaust pipe 112.

In the present embodiment, a temperature control section for controlling the temperature of the crucible 10 for crystal growth schematically includes the heaters 102, the heater control section 106, and the lifting and lowering device 108.

Successively, a method for separating distillates by using the crystal growing apparatus 100 shown in Fig. 2, charging a raw material 20 into the retaining section 12 of the crucible 10 for crystal growth shown in Fig. 1, bringing the interior to a vacuum or depressurized state, and appropriately controlling the temperatures of the sections of the crucible 10 and subsequently growing a crystal by using a highly-purified main distillate is explained.

A series of steps are explained hereunder in reference to the flowchart in Fig. 3 and Figs. 4 to 6.

Firstly, a crucible 10 for crystal growth shown in Fig. 1 in the state of not closing the top end side of a straight pipe section 13 is prepared. The material of the prepared crucible 10 for crystal growth is high-purity silica glass in order to inhibit impurities coming from the crucible 10 from mixing to the greatest possible extent.

Successively, in order to remove impurities attaching to the interior of the crucible 10 for crystal growth, the crucible 10 for crystal growth is washed with hydrofluoric acid having a concentration of 5%, rinsed with pure water five times, and then dried (Step S10).

Successively, after confirming that the interior is dried completely, a thallium bromide material of 3 kg is charged from the top end side of the straight pipe section 13 of the crucible 10 for crystal growth into a retaining section 12 (Step S12).

On this occasion, since the material 20 falls into a crystal growing section 18 when the material 20 is charged directly, a soft hose is inserted from the top end side of the straight pipe section 13 of the crucible 10 for crystal growth, the tip of the hose is introduced into the retaining section 12, and the material 20 is charged through the inside of the hose. When a powdered material is used as the material 20, the material 20 tends to be clogged in the middle and hence it is effective to charge the material 20 little by little while vibration is given.

Further, since thallium bromide is a highly-poisonous material, it is desirable, in the event of operation, to wear protective glasses, a protective mask, impermeable gloves, and work clothes covering a whole body and carry out the operation while the vicinity of an operation site is sucked through an exhaust duct when needed so that the poisonous material may not scatter around.

After finishing charging the material 20, the crucible 10 for crystal growth is arranged in a heating furnace 104 of a crystal growing apparatus 100 shown in Fig. 2, suspended with a stainless wire, and connected to a lifting and lowering device 108. Further, the crucible 10 for crystal growth may possibly not withstand overload and may be broken when a load is applied only to the upper section of the crucible 10 for crystal growth and hence a structure of winding a wire also around a crystal growing section 18 and the lower section of the retaining section 12 and receiving the load with the lower section of the crucible 10 for crystal growth is adopted.

Successively, a vacuum exhaust pipe 12 is connected to the tip of the straight pipe section 13 of the crucible 10 for crystal growth. A trap cooled with liquid nitrogen is mounted on a vacuum exhauster 110 so that the vapor of the raw material 20 may be removed even when the vapor is sucked. A component volatilized at normal temperature is removed by activating the vacuum exhauster 110 in the state, evacuating the air in the interior of the crucible 10 for crystal growth, and retaining the state for one hour (Step S14).

Usually, since thallium bromide is synthesized in an aqueous solution, a large quantity of water may highly possibly attach to the surface. To cope with this, the temperature of the whole crucible 10 for crystal growth is raised gradually while the evacuation of the air is continued in order to remove moisture (Step S16). Concretely, the temperature is raised from room temperature to 100°C for one hour in the state of evacuating the air by the vacuum exhauster 110 and the crucible 10 for crystal growth is retained at 100°C for one hour. Successively, the temperature is raised to 300°C for one hour and the crucible 10 for crystal growth is retained at 300°C for one hour.

Although moisture is more likely to be removed as a temperature rises, the vapor pressure of thallium bromide increases and a large quantity is vaporized undesirably at an excessively high temperature even if the temperature is not higher than a melting point and hence it is desirable to keep an appropriate temperature.

Successively, the vicinity of the tip of the crucible 10 for crystal growth is heat-sealed with a burner (Step S18).

The heat-sealed site is formed at a part lower than the part connected to the vacuum exhaust pipe 112 of the straight pipe section 13 and the heat-sealing operation is carried out while the air in the interior is evacuated. As a result, the interior of the crucible 10 for crystal growth is kept in a vacuum or depressurized state and it is possible to carry out vacuum distillation effectively utilizing the vapor pressure of the raw material 20. The pressure in the interior of the crucible 10 for crystal growth is preferably 500 Pa or less and yet preferably 100 Pa or less in the state where the temperature of thallium bromide is 300°C. After the heat-sealing, the vacuum exhauster 110 is stopped.

Successively, the step shifts to a step for recovering an initial distillate 24 in order to remove the initial distillate 24 containing evaporable impurities in large quantities.

Firstly, the temperatures of the crystal growing section 18, the retaining section 12, and a main distillate condensing section 16 are set at temperatures not lower than the temperature of an initial distillate recovery section 14. Concretely, a heater control section 106 is set so that the temperatures of the crystal growing section 18, the retaining section 12, and the main distillate condensing section 16 may be 600°C and the temperature of the initial distillate recovery section 14 may be 480°C in the crucible 10 for crystal growth and the temperatures are retained for 30 minutes (Step S20).

Through the step, an evaporable component included in the raw material 20 and a part of thallium bromide: move toward the initial distillate recovery section 14 by the temperature gradient caused by lowering the temperature of the initial distillate recovery section 14 to a temperature lower than the temperatures of the crystal growing section 18, the retaining section 12, and the main distillate condensing section 16 (the hollow arrows in Fig. 4); condense at the initial distillate recovery section 14; and are liquefied or solidified as the initial distillate 24 (the state shown in Fig. 4, Step S22).

Here, the substance liquefied at the initial distillate recovery section 14 receives the action of gravity in the state of attaching to the inside of the crucible 10 for crystal growth by surface tension and is introduced into the bottom section of the initial distillate recovery section 14. A pipe section 15 connected to the retaining section 12 protrudes in the center of the initial distillate recovery section 14; hence the tip is located at a position higher than the bottom section of the initial distillate recovery section 14; and thus the liquid initial distillate 24 is accumulated between both the sections. A solidified substance in the initial distillate 24: attaches to the wall surface of the crucible 10 for crystal growth; stays at the site; and hence never intrudes into the crystal growing section 18. Further, since the temperature of the crystal growing section 18 is high, the vapor of the initial distillate 24 never condenses at the crystal growing section 18.

At the initial distillate recovery step, when the quantity of recovered initial distillate 24 is increased, the quantity of removed impurities can also be increased but the loss of the raw material 20 also increases. Consequently, it is appropriate to recover about 10% of a charged raw material 20 as the initial distillate 24. Further, since the succeeding steps require a long time, it is also possible to once lower the temperature of the initial distillate recovery section 14 to 300°C and the temperature of the other sections to 480°C and then shift to the succeeding steps next day or later.

After the step for recovering the initial distillate 24, the step shifts to a step for recovering a main distillate 30 where the main distillate 30 having small quantity of impurities is introduced into the crystal growing section 18. Firstly, the temperatures of the crystal growing section 18 and the main distillate condensing section 16 in the crucible 10 for crystal growth are lowered to temperatures close to the melting point of the raw material 20. Concretely, the heater temperature section 106 is set so that the temperatures of the crystal growing section 18 and the main distillate condensing section 16 may be 480°C, the temperature of the retaining section 12 may be 600°C, and the temperature of the initial distillate recovery section 14 may be 300°C. Then the state is retained for 5 hours (Step S24).

In the state of Step S24, the vapor generated from the raw material 20 (the hollow arrows in Fig. 5) condenses and is liquefied (to a condensed raw material 26) at the main distillate condensing section 16, or at the pipe section 15 at the latest, before it reaches the initial distillate recovery section 14 and attaches to the pipe wall on the side of the interior of the main distillate condensing section 16 in the crucible 10 for crystal growth. The attached condensed raw material 26: moves toward the center along the wall surface of the downward convex of the main distillate condensing section 16; turns to a droplet 28 and drops finally; and is introduced into the crystal growing section 18 through a pipe section 17 (the state shown in Fig. 5).

As a result, it is possible to recover the main distillate 30 having the least impurities in the crystal growing section 18. Further, since it is unnecessary to heat-seal a pipe connecting the main distillate condensing section 16 to the initial distillate recovery section 14, it is possible to shift from the step for recovering the initial distillate 24 to the step for recovering the main distillate 30 safely and efficiently.

Here, although it is possible to increase the speed of distillation by increasing the temperature of the retaining section 12, hardly evaporable impurities are likely to vaporize at the same time and the purity of the main distillate 30 may lower undesirably. When a distillation speed is increased without lowering the purity of the main distillate 30, it is desirable to lower the partial pressure of the gas component other than the raw material 20 in the crucible 10 for crystal growth to a maximum extent and make the most of the gas in the crucible 10 for crystal growth comprise the vapor of the raw material 20.

Further, when the main distillate 30 continues to be recovered, hardly evaporable impurities accumulate in the raw material 20 in the retaining section 12 and hence the purity of the main distillate 30 lowers as the quantity of the recovered main distillate 30 increases. For the reason, the heater control section 106 is set so that the temperature of the retaining section 12 may be lowered to a temperature of scarcely causing vaporization, concretely to 480°C, in the state of leaving some of the raw material 20 in the retaining section 12 and the recovery of the main distillate 30 is finished (Step S26, the state shown in Fig. 6).

Here, although some of the raw material 20 is left in the retaining section 12, an appropriate quantity of the remaining part is roughly around 10% of the quantity of a charged raw material 20. Although it is possible to continue to recover the main distillate 30 until the raw material 20 in the retaining section 12 is consumed completely as a matter of course, on this occasion, since a black impurity residue remains in the retaining section 12 and is hardly prevented completely from vaporizing, it is desirable to leave the raw material 20 to some extent in the retaining section 12.

Successively, the crucible 10 for crystal growth is uplifted with the lifting and lowering device 108 until the crystal growing section 18 comes to the position of the retaining section 12 (Step S28).

Through the step: the initial distillate recovery section 14 goes outside the heating furnace 104; the temperature lowers to a temperature close to room temperature; and the temperatures of the main distillate condensing section 16 and the retaining section 12 come to be 300°C. As a result, the raw material 20 remaining at the sites is cooled to a melting point or lower and solidifies and the possibility of moving to another site is eliminated.

Successively, the heater control section 106 is set so that the temperature of the space formed below the crystal growing section 18 by uplifting the crucible 10 for crystal growth may be 370°C and the temperature of the crystal growing section 18 may be 480°C (Step S30). The growth of a crystal commences by using the temperature difference at the crystal growing section 18.

In order to shift to a crystal growing step, the crucible 10 for crystal growth is lowered with the lifting and lowering device 108 and the liquid main distillate 30 is cooled from the lower part of the crucible 10 for crystal growth and solidified (Step S32). The descending speed of the crucible 10 for crystal growth on this occasion is set at 0. 1 to 2 mm per hour for example. As the descending speed reduces, a crystal of good quality is likely to be obtained but the descending time extends, and hence an appropriate descending speed is about 0.5 to 1 mm per hour in manufacturing.

By controlling the temperatures of the sites in the crucible 10 for crystal growth in this way, it is possible to recover only the main distillate 30 having small impurities in the crystal growing section 18. Further, by cooling and solidifying the recovered main distillate 30 while a temperature gradient is given, it is possible to shift to the crystal growing step without exposing the main distillate 30 in the atmosphere.

After the whole main distillate 30 in the crystal growing section 18 is crystallized, the crucible 10 for crystal growth is crushed and a crystal ingot in the interior is taken out (Step S34). On this occasion, attention is paid so that force may not be applied to the crystal to the greatest possible extent and operation is carried out by wearing protective gloves in a clean bench having a sufficient volume of wind so as not to inhale the dust of thallium bromide. The crystal ingot is light yellow and transparent and the initial distillate is light yellow and opaque. In contrast, the residue in the retaining section 12 is brown and opaque and they show color tones reflecting the quantities of the impurities respectively.

As a result of measuring the quantities of impurities in an obtained crystal ingot by glow discharge mass spectrometry (GDMS), Mg, Na, Zn, and As that are evaporable impurity elements and Ti, Mn, and O that are hardly evaporable impurity elements are 1 ppm or less respectively. Although Si is contained by the reaction between the material of the crucible 10 for crystal growth and thallium bromide, the quantity is 10 ppm or less.

Further, the interior of the crystal ingot is basically a single crystal, a crystal interface caused by the simultaneous growth of a plurality of crystal nuclei is seen sometimes, but even in the case the number of crystals seen when they are observed from the top end of the crystal ingot is 5 or less. Here, since the crystal ingot is sliced to a chip of several-millimeter square when it is used in a detector, it may be used by avoiding a crystal interface but the crystal ingot may desirably be a single crystal of no crystal interface to the greatest possible extent from the viewpoint of yield.

As stated above, in the first embodiment of a crucible for crystal growth, a crystal growing apparatus provided therewith, and a method for growing a crystal according to the present invention, as a crucible 10 for crystal growth used for growing a crystal, a crucible having a retaining section 12 for retaining a raw material 20, an initial distillate recovery section 14 for recovering an initial distillate 24 when the raw material 20 retained in the retaining section 12 is vaporized, a main distillate condensing section 16 for condensing a main distillate when the raw material 20 retained in the retaining section 12 is vaporized, and a crystal growing section 18 for retaining a main distillate 30 comprising a raw material melt 28 condensed at the main distillate condensing section 16 and generating a crystal when the crystal is grown from the retained main distillate 30 is used.

As a result, it is possible to: remove the initial distillate 24 having a high impurity concentration easily when vacuum distillation is carried out; and obtain a crystal material of a high purity. Further, by controlling the temperatures of the sections in the crucible 10 for crystal growth without applying a heat-sealing step of the pipe section 15 and the like after the removal of the initial distillate 24, it is possible to shift rapidly to the recovery operation of the main distillate 30. For the reason, high safeness is secured and it is possible to: shift to the crystal growing step rapidly while contact with the outer world is avoided even when the main distillate 30 is successively crystallized; and prevent contamination from the exterior more securely.

By those effects, it is possible to: highly purify the raw material 20 efficiently and sufficiently; and manufacture a semiconductor crystal of high quality with a high degree of efficiency.

### <Second Embodiment>

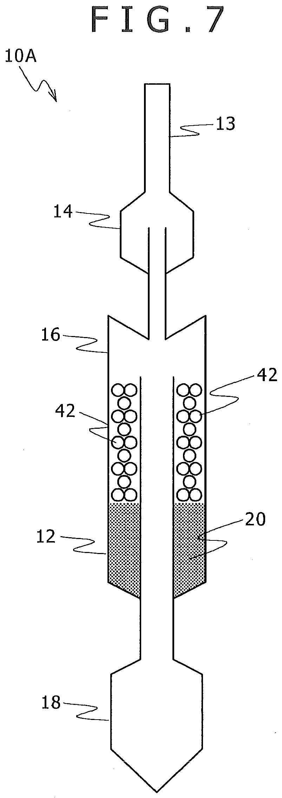

A second embodiment of a crucible for crystal growth according to the present invention is explained in reference to Fig. 7.

Fig. 7 is a schematic view showing the structure of a crucible for crystal growth in the second embodiment according to the present invention.

As shown in Fig. 7, a crucible 10A for crystal growth according to the second embodiment of the present invention has a filler for distillation 42 on the upper side of a retaining section 12, which is the side of a main distillate condensing section 16, in addition to the configuration of a crucible 10 for crystal growth according to the first embodiment.

The filler for distillation 42 includes an inert material having a large surface area and silica glass or the like is named as the material for example. The sectional shape of the filler for distillation 42 is nearly round in Fig. 7 but is not limited to the shape. Another material can be used as the filler for distillation 42 as long as the material is an inert material but, when a material having a density larger than a raw material charged in the retaining section 12 is used, a mechanism for retaining the filler for distillation 42 above the raw material is required and a method of inserting a platform for example is conceivable.

Except that the filler for distillation 42 is provided, the configuration is nearly the same as the crucible 10 for crystal growth according to the first embodiment and the details are omitted.

When a step for recovering an initial distillate 24 and a step for retaining a main distillate with the crucible 10A for crystal growth are carried out, a heater control section 106 is set so that the temperature of a part of the filler for distillation 42 close to the retaining section 12 may be high and the temperature may lower toward the top end of the filler for distillation 42, namely the main distillate condensing section 16.

A series of steps for growing a crystal are explained hereunder with a focus on the points different from the first embodiment.

Firstly, a crucible 10A for crystal growth shown in Fig. 7 is prepared. Many short pipes having silica glass are prepared as a filler for distillation 42 in the crucible 10A for crystal growth.

After a raw material is charged into the prepared crucible 10A for crystal growth, the filler for distillation 42 is charged.

Successively, during initial distillate recovery, a heater control section 106 is set so that the temperatures of a crystal growing section 18 and a retaining section 12 may be 600°C, the temperature of the top end of the filler for distillation 42 may be 480°C, the temperature of a main distillate condensing section 16 may be 520°C, and the temperature of an initial distillate recovery section 14 may be 480°C in the crucible 10A for crystal growth and the temperatures are retained for 1 hour. Here, in the present embodiment of using the filler for distillation 42, the shift of vapor to the initial distillate recovery section 14 is delayed and hence the retention time has to be prolonged in comparison with the initial distillate recovery step in the first embodiment.

Successively, during main distillate recovery, the heater control section 106 is set so that the temperatures of the crystal growing section 18, the top end of the filler for distillation 42, and the main distillate condensing section 16 may be 480°C, the temperature of the retaining section 12 may be 600°C, and the temperature of the initial distillate recovery section 14 may be 300°C in the crucible 10A for crystal growth and the temperatures are retained for 10 hours. Succeeding steps are similar to the steps in the first embodiment.

As a result of measuring the quantities of impurities in an obtained crystal ingot by glow discharge mass spectrometry, Mg, Na, Zn, and As that are evaporable impurity elements and Ti, Mn, and O that are hardly evaporable impurity elements are 0.5 ppm or less respectively. Si is 5 ppm or less and a good result is obtained in comparison with the crystal in the first embodiment.

In the second embodiment of a crucible for crystal growth according to the present invention too, effects nearly similar to the first embodiment of the crucible for crystal growth stated earlier can be obtained. That is, it is possible to: highly purify a raw material 20 efficiently and sufficiently; and manufacture a semiconductor crystal of high quality with a high degree of efficiency.

In addition, the vapor that is generated in the retaining section 12 and ascends condenses again and is liquefied at the filler for distillation 42, and descends by the action of gravity. Then the liquid vaporizes again by the high temperature of the retaining section 12 in the middle of the descent. In this way, it is possible to repeat the vaporization and liquefaction of a raw material 20. Since the separation action of impurities in distillation is caused by a phase change between a gas and a liquid, the separation efficiency increases as the frequency of the vaporization and the liquefaction increases and a main distillate for crystal growth of a higher purity can be obtained.

### <Third Embodiment>

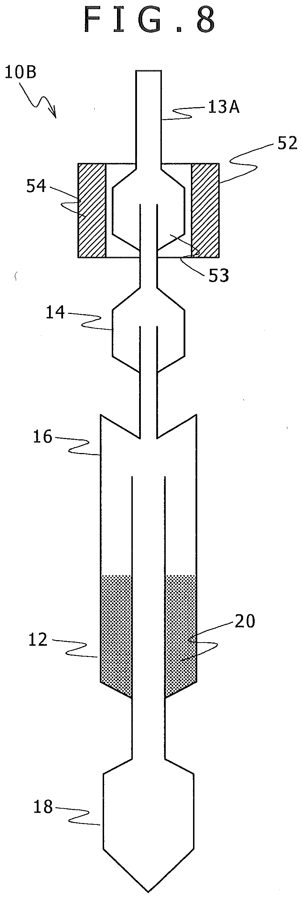

A third embodiment of a crucible for crystal growth according to the present invention is explained in reference to Fig. 8.

Fig. 8 is a schematic view showing the structure of a crucible for crystal growth in the third embodiment according to the present invention.

As shown in Fig. 8, a crucible 10B for crystal growth according to the third embodiment of the present invention has a coaxial cold trap 52 at a straight pipe section 13A of the upper part of an initial distillate recovery section 14 in addition to the configuration of a crucible 10 for crystal growth according to the first embodiment.

The coaxial cold trap 52 has a trap section 53 for effectively removing impurities of low boiling points, for example water and silicon bromide, and a cooling section 54 for cooling the trap section 53. By cooling the trap section 53 of the coaxial cold trap 52 to a temperature not higher than 0°C, it is possible to effectively remove impurities of low boiling points, for example water and silicon bromide.

The configuration other than the coaxial cold trap 52 is nearly the same as the crucible 10 for crystal growth according to the first embodiment and the details are omitted.

A series of steps for growing a crystal are explained hereunder with a focus on the points different from the first embodiment.

Firstly, a crucible 10B for crystal growth shown in Fig. 8 is prepared.

After a raw material is charged to a retaining section 12 of the prepared crucible 10B for crystal growth, in an initial distillate recovery step, a heater control section 106 is set so that the temperatures of a crystal growing section 18, the retaining section 12, and a main distillate condensing section 16 may be 600°C and the temperature of an initial distillate recovery section 14 may be 480°C in the crucible 10B for crystal growth, the temperature of a cooling section 54 is controlled so that the temperature of a trap section 53 of a coaxial cold trap 52 may be -20°C, and the temperatures are retained for 30 minutes.

As the step advances, a white solid matter accumulates at the trap section 53 of the coaxial cold trap 52 but the quantity is about the extent of covering a sidewall.

Successively, the step advances to a main distillate recovery step, the heater control section 106 is set so that the temperatures of the crystal growing section 18 and the main distillate condensing section 16 may be 480°C, the temperature of the retaining section 12 may be 600°C, and the temperature of the initial distillate recovery section 14 may be 300°C in the crucible 10B for crystal growth, the temperature of the cooling section 54 is controlled so that the temperature of the trap section 53 of the coaxial cold trap 52 may be -20°C, and the temperatures are retained for 5 hours. During the time too, a white solid matter continues to accumulate at the trap section 53 of the coaxial cold trap 52. Successively, steps similar to the first embodiment are carried out.

As a result of measuring the quantities of impurities in an obtained crystal ingot by glow discharge mass spectrometry, Mg, Na, Zn, and As that are evaporable impurity elements and Ti and Mn that are hardly evaporable impurity elements were 1 ppm or less respectively. Further, O was 0.5 ppm or less and Si was 5 ppm or less.

In the third embodiment of a crucible for crystal growth according to the present invention too, effects nearly similar to the first embodiment of the crucible for crystal growth stated earlier can be obtained. That is, it is possible to: highly purify a raw material 20 efficiently and sufficiently; and manufacture a semiconductor crystal of high quality with a high degree of efficiency.

In addition, it is possible to: effectively remove impurities of low boiling points, for example water and silicon bromide, by the coaxial cold trap 52; and further reduce the impurity concentration in a crystal to be grown.

### <Fourth Embodiment>

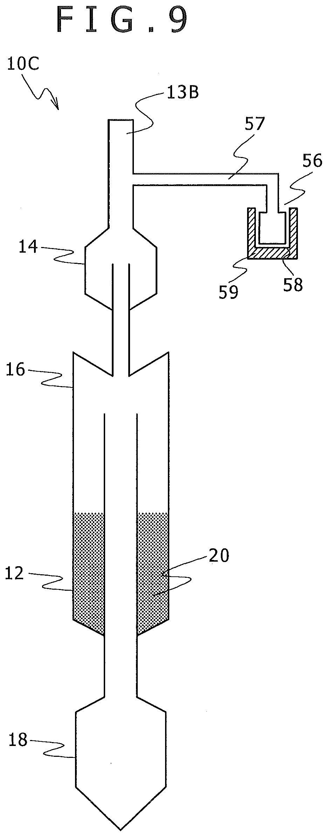

A fourth embodiment of a crucible for crystal growth according to the present invention is explained in reference to Fig. 9.

Fig. 9 is a schematic view showing the structure of a crucible for crystal growth in the fourth embodiment according to the present invention.

As shown in Fig. 9, a crucible 10C for crystal growth according to the fourth embodiment of the present invention has a parallel cold trap 56 on the side of an initial distillate recovery section 14 in addition to the configuration of a crucible 10 for crystal growth according to the first embodiment.

The parallel cold trap 56 is arranged on the side of the initial distillate recovery section 14 and has a parallel pipe 57 one end of which is connected to a straight pipe section 13b, a trap section 58 connected to the other end of the parallel pipe 57, and a cooling section 59 for cooling the trap section 58.

The configuration other than the parallel cold trap 56 is nearly the same as the crucible 10 for crystal growth according to the first embodiment and the details are omitted.

A series of steps for growing a crystal are explained hereunder with a focus on the points different from the first embodiment.

Firstly, a crucible 10C for crystal growth shown in Fig. 9 is prepared.

After a raw material is charged to a retaining section 12 of the prepared crucible 10C for crystal growth, in an initial distillate recovery step, a heater control section 106 is set so that the temperatures of a crystal growing section 18, the retaining section 12, and a main distillate condensing section 16 may be 600°C and the temperature of an initial distillate recovery section 14 may be 480°C in the crucible 10C for crystal growth, the temperature of a cooling section 59 is controlled so that the temperature of a trap section 58 of a parallel cold trap 56 may be -40°C, and the temperatures are retained for 30 minutes.

As the step advances, a white solid matter accumulates at the trap section 58 of the parallel cold trap 56 but the quantity is about the extent of covering a sidewall.

Successively, the step advances to a main distillate recovery step, the heater control section 106 is set so that the temperatures of the crystal growing section 18 and the main distillate condensing section 16 may be 480°C, the temperature of the retaining section 12 may be 600°C, and the temperature of the initial distillate recovery section 14 may be 300°C in the crucible 10C for crystal growth, the temperature of the cooling section 59 is controlled so that the temperature of the trap section 58 of the parallel cold trap 56 may be -40°C, and the temperatures are retained for 5 hours. During the time too, a white solid matter continued to accumulate at the trap section 58 of the parallel cold trap 56. Successively, steps similar to the first embodiment are carried out.

As a result of measuring the quantities of impurities in an obtained crystal ingot by glow discharge mass spectrometry, Mg, Na, Zn, and As that are evaporable impurity elements and Ti and Mn that are hardly evaporable impurity elements were 1 ppm or less respectively. Further, O was 0.3 ppm or less and Si was 3 ppm or less.

In the fourth embodiment of a crucible for crystal growth according to the present invention too, effects nearly similar to the first embodiment of the crucible for crystal growth stated earlier can be obtained. That is, it is possible to: highly purify a raw material 20 efficiently and sufficiently; and manufacture a semiconductor crystal of high quality with a high degree of efficiency.

In addition, by cooling the parallel cold trap 56 to 0°C or lower, it is possible to effectively remove impurities of low boiling points, for example water and silicon bromide, in the same manner as the third embodiment.

Further, by installing the parallel cold trap 56 on the side of the initial distillate recovery section 14, it is possible to inhibit the influence of air of a high temperature coming upward from a heating furnace 104 and the temperature of the parallel cold trap 56 is more likely to be lowered. Consequently, it is possible to: improve the recovery rate of the impurities of low boiling points; carry out operation even when the performance of the cooling section 59 is low; and further reduce the impurity concentration of a crystal to be grown.

### <Fifth Embodiment>

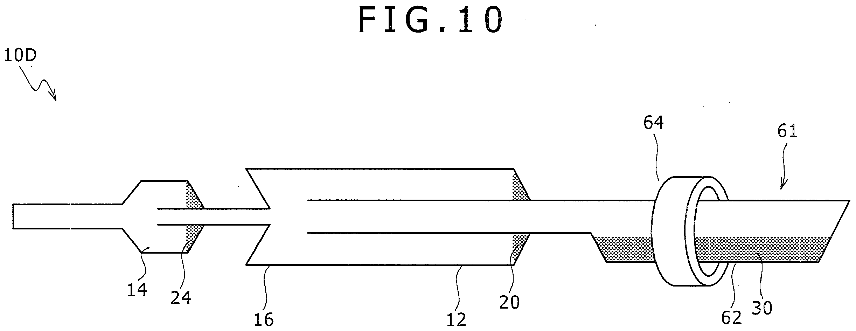

A fifth embodiment of a crucible for crystal growth according to the present invention is explained in reference to Fig. 10.

Fig. 10 is a schematic view showing the structure of a crucible for crystal growth in the fifth embodiment according to the present invention.

As shown in Fig. 10, a crucible 10D for crystal growth according to the fifth embodiment of the present invention has a crystal growing section 61 further having a zone refining section 62 and a movable heater 64 in place of a crystal growing section 18 in a crucible 10 for crystal growth according to the first embodiment.

As shown in Fig. 10, the crucible 10D for crystal growth according to the present embodiment has the thick zone refining section 62 for carrying out zone refining in the crystal growing section 61 and is installed vertically and a main distillate is recovered, and successively the zone refining can be carried out by laying down the crucible 10D for crystal growth and heating it with the movable heater 64.

The configuration other than the crystal growing section 61 is nearly the same as the crucible 10 for crystal growth according to the first embodiment and the details are omitted.

A series of steps for growing a crystal are explained hereunder with a focus on the points different from the first embodiment.

After the step is carried out up to a main distillate recovery step with a crucible 10D for crystal growth shown in Fig. 10, the temperature of the whole crucible 10D for crystal growth is cooled gradually to 40°C or lower and the crucible 10D for crystal growth is extracted from a heating furnace 104.

Successively, the crucible 10D for crystal growth is laid down and the temperature of a movable heater 64 is set so as to be 600°C. When the temperature of the movable heater 64 reaches 600°C, a tip (right side in Fig. 10) of a zone refining section 62 in a crystal growing section 61 is heated, a solid in the interior is melted, the movable heater 64 is shifted gradually in the direction of the left in Fig. 10, and a content is spread evenly. Then the movable heater 64 is moved from an end to the other end at a speed of 2 mm per hour, the movement is repeated several times, and thus zone refining is carried out. Finally, the movable heater 64 is moved at a speed of 0.5 mm per hour and thus a crystal is grown.

As a result of measuring the quantities of impurities in an obtained crystal ingot by glow discharge mass spectrometry, Mg, Na, and Zn that are evaporable impurity elements and Ti, Mn, and O that are hardly evaporable impurity elements were 0.5 ppm or less respectively. Si was 3 ppm or less. On the other hand, As was 1 ppm or less.

In the fifth embodiment of a crucible for crystal growth according to the present invention too, effects nearly similar to the first embodiment of the crucible for crystal growth stated earlier can be obtained. That is, it is possible to: highly purify a raw material 20 efficiently and sufficiently; and manufacture a semiconductor crystal of high quality with a high degree of efficiency.

In addition, because a distilled material can be used for zone refining without touching outside world, the step is very usable when a crystal of a higher purity is grown.

Here, in the event of phase change between a solid and a liquid, because As is likely to be taken into the solid side of thallium bromide and hence is hardly removed at the zone refining, it is desirable to remove As sufficiently beforehand in a distillation step.

### <Sixth Embodiment>

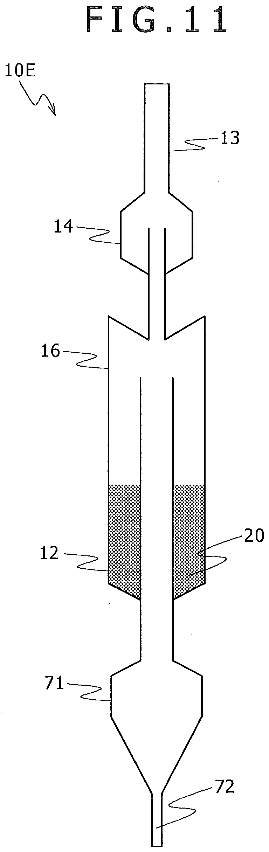

A sixth embodiment of a crucible for crystal growth according to the present invention is explained in reference to Fig. 11.

Fig. 11 is a schematic view showing the structure of a crucible for crystal growth in the sixth embodiment according to the present invention.

As shown in Fig. 11, a crucible 10E for crystal growth according to the sixth embodiment of the present invention has a seed crystal generating section 72 at the lower part of a crystal growing section 71 in addition to the configuration of a crucible 10 for crystal growth according to the first embodiment.

The seed crystal generating section 72 is a shin tubular part arranged at the lower part of the crystal growing section 71 as shown in Fig. 11.

The configuration other than the seed crystal generating section 72 is nearly the same as the crucible 10 for crystal growth according to the first embodiment and the details are omitted.

A series of steps for growing a crystal are explained hereunder with a focus on the points different from the first embodiment.

After the step is carried out up to a main distillate recovery step with a crucible 10E for crystal growth shown in Fig. 11, the crucible 10E for crystal growth is lifted until a seed crystal generating section 72 comes to the position of a retaining section 12 with a lifting and lowering device 108 of a crystal growing apparatus 100.

Successively, the crucible 10E for crystal growth is lowered with the lifting and lowering device 108 and a liquid main distillate is cooled from the lower part of the crucible 10E for crystal growth and solidified. The lowering speed of the crucible 10E for crystal growth is 0.1 to 2 mm per hour.

An obtained crystal ingot comprises single-crystals mostly and, even in the case where a crystal interface exists, the number of crystals seen when the crystals are observed from the top end of the crystal ingot is three or less.

In the sixth embodiment of a crucible for crystal growth according to the present invention too, effects nearly similar to the first embodiment of the crucible for crystal growth stated earlier can be obtained. That is, it is possible to: highly purify a raw material 20 efficiently and sufficiently; and manufacture a semiconductor crystal of high quality with a high degree of efficiency.

In addition, by having the seed crystal generating section 72, when a seed crystal is generated at the seed crystal generating section 72 during crystal growth, a crystal grown biggest intrudes into the crystal growing section 71, the crystal growth is further accelerated with the biggest crystal acting as the base point, and thus a single crystal can be obtained more securely.

### <Seventh Embodiment>

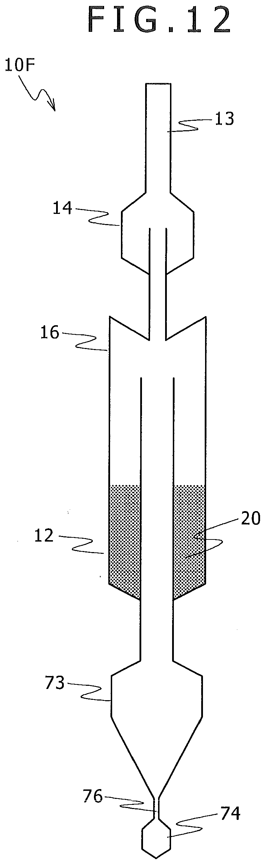

A seventh embodiment of a crucible for crystal growth according to the present invention is explained in reference to Fig. 12.

Fig. 12 is a schematic view showing the structure of a crucible for crystal growth in the seventh embodiment according to the present invention.

As shown in Fig. 12, a crucible 10F for crystal growth according to the seventh embodiment of the present invention has a seed crystal selecting section 76 at the lower part of a crystal growing section 73 and a seed crystal generating section 74 at the lower part of the seed crystal selecting section 76 in addition to the configuration of a crucible 10 for crystal growth according to the first embodiment.

The seed crystal selecting section 76 is a thin tubular part formed at the lower part of the crystal growing section 73 and the seed crystal generating section 74 is a tubular part having a diameter larger than the seed crystal selecting section 76 and being formed at the lower part of the seed crystal selecting section 76.

The configuration other than the seed crystal selecting section 76 and the seed crystal generating section 74 is nearly the same as the crucible 10 for crystal growth according to the first embodiment and the details are omitted.

A series of steps for growing a crystal are explained hereunder with a focus on the points different from the first embodiment.

After the step is carried out up to a main distillate recovery step with a crucible 10F for crystal growth shown in Fig. 12, the crucible 10F for crystal growth is lifted until a seed crystal generating section 74 comes to the position of a retaining section 12 with a lifting and lowering device 108 of a crystal growing apparatus 100.

Successively, the crucible 10F for crystal growth is lowered with the lifting and lowering device 108 and a liquid main distillate is cooled from the lower part of the crucible 10F for crystal growth and solidified. The lowering speed of the crucible 10F for crystal growth is 0.1 to 2 mm per hour.

An obtained crystal ingot comprised single-crystals in most cases and, even in the case where a crystal interface existed, the number of crystals seen when the crystals are observed from the top end of the crystal ingot was two or less.

In the seventh embodiment of a crucible for crystal growth according to the present invention too, effects nearly similar to the first embodiment of the crucible for crystal growth stated earlier can be obtained. That is, it is possible to: highly purify a raw material 20 efficiently and sufficiently; and manufacture a semiconductor crystal of high quality with a high degree of efficiency.

In addition, although the number of seed crystals generated during crystal growth at the seed crystal generating section 74 is not limited to one, by installing the thin seed crystal selecting section 76, it is possible to: introduce only a seed crystal that has reached the lower end of the seed crystal selecting section 76 to a crystal growing section 73; and further increase the possibility that an obtained crystal ingot comprises a single crystal accordingly.

### <Eighth Embodiment>

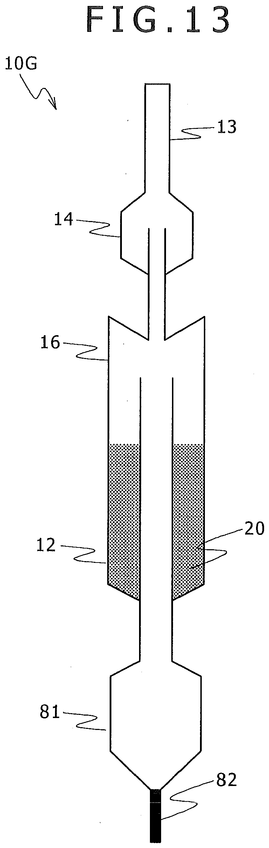

An eighth embodiment of a crucible for crystal growth according to the present invention is explained in reference to Fig. 13.

Fig. 13 is a schematic view showing the structure of a crucible for crystal growth in the eighth embodiment according to the present invention.

As shown in Fig. 13, a crucible 10G for crystal growth according to the eighth embodiment of the present invention has a cooling bar 82 at the lower part of a crystal growing section 81 in addition to the configuration of a crucible 10 for crystal growth according to the first embodiment.

As shown in Fig. 13, the cooling bar 82 is a part connected to the lower end of the crystal growing section 81 and is installed in order to cool the lower end of the crystal growing section 81 more securely during crystal growth.

The configuration other than the cooling bar 82 is nearly the same as the crucible 10 for crystal growth according to the first embodiment and the details are omitted.

A series of steps for growing a crystal are explained hereunder with a focus on the points different from the first embodiment.

After the step is carried out up to a main distillate recovery step with a crucible 10G for crystal growth shown in Fig. 13, the crucible 10G for crystal growth is lifted until a cooling bar 82 comes to the position of a retaining section 12 with a lifting and lowering device 108 of a crystal growing apparatus 100.

Successively, the crucible 10G for crystal growth is lowered with the lifting and lowering device 108 and a liquid main distillate is cooled from the lower part of the crucible 10G for crystal growth and solidified. The lowering speed of the crucible 10G for crystal growth is 0.1 to 2 mm per hour.

An obtained crystal ingot comprises single-crystals mostly and, even in the case where a crystal interface exists, the number of crystals seen when the crystals are observed from the top end of the crystal ingot is three or less.

In the eighth embodiment of a crucible for crystal growth according to the present invention too, effects nearly similar to the first embodiment of the crucible for crystal growth stated earlier can be obtained. That is, it is possible to: highly purify a raw material 20 efficiently and sufficiently; and manufacture a semiconductor crystal of high quality with a high degree of efficiency.

In addition, by having the cooling bar 82, the temperature gradient between the lower part and the upper part of a crystal growing section 81 can be maintained easily and a crystal ingot having few crystal interfaces can be obtained more securely.

### <Ninth Embodiment>

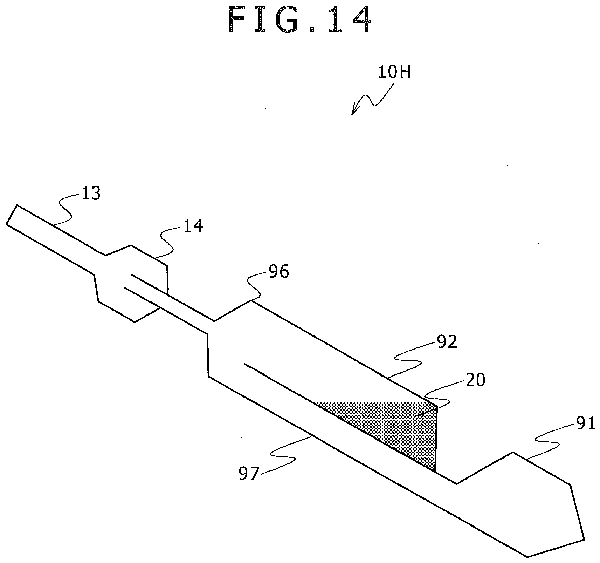

A ninth embodiment of a crucible for crystal growth according to the present invention is explained in reference to Fig. 14.

Fig. 14 is a schematic view showing the structure of a crucible for crystal growth in the ninth embodiment according to the present invention.

As shown in Fig. 14, a crucible 10H for crystal growth according to the ninth embodiment of the present invention is structured so that a main distillate condensing section 96 may not have the structure of a downward convex in comparison with a crucible 10 for crystal growth according to the first embodiment.

As shown in Fig. 14, the crucible 10H for crystal growth according to the present embodiment does not have the structure of a downward convex for the main distillate condensing section 96 introducing a main distillate to a crystal growing section 91 and instead a retaining section 92 and the main distillate condensing section 96 are arranged so that a main distillate condensed at the main distillate condensing section 96 may be introduced into the crystal growing section 91 through a pipe channel 97 by gravity during distillation by arranging the crucible 10H for crystal growth obliquely.

A series of steps for growing a crystal are explained hereunder with a focus on the points different from the first embodiment.

A crystal growing apparatus having a crucible 10H for crystal growth shown in Fig. 14 and a heating furnace configured so as to be able to change the installation angle is prepared. The prepared crucible 10H for crystal growth is inserted into and fixed to the heating furnace so as to be oblique and an initial distillate recovery step and a main distillate recovery step are carried out. The temperature setting condition on this occasion is the same as the condition in the first embodiment.

Successively, the crucible 10H for crystal growth is set at an upright position and crystal growth is carried out.

As a result of measuring the quantities of impurities in an obtained crystal ingot by glow discharge mass spectrometry, Mg, Na, Zn, and As that are evaporable impurity elements and Ti, Mn, and O that are hardly evaporable impurity elements were 1 ppm or less respectively. Si was 10 ppm or less.

Further, mostly the interior of a crystal ingot comprised a single crystal and sometimes a crystal interface caused by the simultaneous growth of two or more crystal nuclei was seen but, on this occasion too, the number of crystals seen when the crystals were observed from the top end of the crystal ingot was 5 or less.

In the ninth embodiment of a crucible for crystal growth according to the present invention too, effects nearly similar to the first embodiment of the crucible for crystal growth stated earlier can be obtained. That is, it is possible to: highly purify a raw material 20 efficiently and sufficiently; and manufacture a semiconductor crystal of high quality with a high degree of efficiency.

### <Others>

Here, the present invention is not limited to the above embodiments and can be variously modified and applied. The above embodiments are explained in detail in order to facilitate the comprehension of the present invention and are not necessarily limited to the cases having all the configurations explained. Further, it is also possible to replace a part of the configuration of an embodiment with the configuration of another embodiment or add the configuration of an embodiment to the configuration of another embodiment. Furthermore, with regard to a part of the configuration of each embodiment, it is also possible to add, delete, or replace another configuration.

For example, although the explanations have been made on the basis of the case of having a main distillate condensing section in the above embodiments, it is also possible to use a crucible for crystal growth not having a main distillate condensing section. In this case, however, since a part of a main distillate shifts to an initial distillate recovery section, it is difficult to increase the efficiency for recovering a main distillate to a crystal growing section in comparison with a crucible for crystal growth having a main distillate condensing section. For the reason, it is desirable to use a crucible for crystal growth having a main distillate condensing section.

In addition, although thallium bromide has been exemplified as a crystal to be grown in the above embodiments, a crystal to be grown is not limited to the material and the present invention can be applied to the growth of a crystal of cadmium telluride, cadmium/zinc/tellurium, or gallium arsenide for example.

### List of Reference Signs

10, 10A, 10B, 10C, 10D, 10E, 10F, 10G, 10H: Crucible for crystal growth
12, 92: Retaining section
13, 13A, 13B: Straight pipe section
14: Initial distillate recovering section
15, 17, 97: Flow of material vapor
16, 96: Main distillate condensing section
18, 61, 71, 73, 81, 91: Crystal growing section
20: Raw material
24: Initial distillate
26: Condensed raw material
28: Raw material melt
30: Main distillate
42: Filler for distillation
52: Coaxial cold trap
53: Trap section
54: Cooling section
56: Parallel cold trap
57: Parallel pipe
58: Trap section
59: Cooling section
62: Zone refining section
64: Movable heater
72, 74: Seed crystal generating section
76: Seed crystal selecting section
82: Cooling bar
100: Crystal growing apparatus
102: Heater
104: Heating furnace
106: Heater control section
108: Lifting and lowering device
109: Support
110: Vacuum exhauster
112: Vacuum exhaust pipe

## Claims

1. A crucible for crystal growth comprising:
a retaining section for retaining a raw material;
an initial distillate recovery section for recovering an initial distillate when the raw material retained at the retaining section has been vaporized; and
a crystal growing section for recovering a main distillate when the raw material retained at the retaining section has been vaporized and growing a crystal.

2. The crucible for crystal growth according to Claim 1, wherein the crucible for crystal growth further has a main distillate condensing section for condensing the main distillate when the raw material retained at the retaining section has been vaporized; and
the crystal growing section recovers a raw material melt condensed at the main distillate condensing section and retains the raw material melt.

3. The crucible for crystal growth according to Claim 1, further comprising a filler for distillation between the retaining section and the crystal growing section.

4. The crucible for crystal growth according to Claim 1, comprising a coaxial cold trap at an upper part of the initial distillate recovery section.

5. The crucible for crystal growth according to Claim 1, comprising a parallel cold trap on a side of the initial distillate recovery section.

6. The crucible for crystal growth according to Claim 1, wherein the crystal growing section further has a zone refining section.

7. The crucible for crystal growth according to Claim 1, further comprising a seed crystal generating section at a lower part of the crystal growing section.

8. The crucible for crystal growth according to Claim 1, further comprising a seed crystal selecting section at the lower part of the crystal growing section and a seed crystal generating section at the lower part of the seed crystal selecting section.

9. The crucible for crystal growth according to Claim 1, further comprising a cooling bar at the lower part of the crystal growing section.

10. A crystal glowing apparatus having:
the crucible for crystal growth according to Claim 1;
a heating furnace for heating the crucible for crystal growth; and
a temperature control section for controlling the temperature of the crucible for crystal growth.

11. The crystal glowing apparatus according to Claim 10, wherein the temperature control section individually heats and controls the retaining section, the initial distillate recovery section, and the crystal growing section in the crucible for crystal growth.

12. A method for growing a crystal, comprising the steps of:
charging a raw material to a retaining section of a crucible for crystal growth having the retaining section for retaining the raw material, an initial distillate recovery section for recovering an initial distillate when the raw material retained in the retaining section has been vaporized, and a crystal growing section for recovering a main distillate when the raw material retained in the retaining section has been vaporized and growing a crystal;
depressurizing and sealing the crucible for crystal growth;
heating the crucible for crystal growth, vaporizing the raw material, and recovering the initial distillate into the initial distillate recovery section and the main distillate into the crystal growing section; and
growing a crystal from the main distillate recovered at the crystal growing section.

13. The method for growing a crystal according to Claim 12,
wherein a crucible further having a main distillate condensing section for condensing the main distillate when the raw material retained in the retaining section has been vaporized is used as the crucible for crystal growth; and
at a step for recovering the main distillate into the crystal growing section, a raw material melt condensed at the main distillate condensing section is recovered at the crystal growing section and retained.

14. The method for growing a crystal according to Claim 12, wherein a crystal of thallium bromide is grown as a crystal to be grown.

15. The method for growing a crystal according to Claim 13, wherein, at a step for recovering the initial distillate into the initial distillate recovery section, the temperature of the initial distillate recovery section is set so as to be lower than the temperatures of the retaining section, the main distillate condensing section, and the crystal growing section in the crucible for crystal growth.

16. The method for growing a crystal according to Claim 13, wherein, at a step for recovering the main distillate into the crystal growing section, in the crucible for crystal growth:
the temperature of the main distillate condensing section is set at a temperature at which the raw material condenses; and
the temperature of the initial distillate recovery section is set so as to be lower than the temperatures of the main distillate condensing section and the crystal growing section.
